# EUROPEAN PATENT APPLICATION

(11) **EP 4 810 976 A1**
(43) Date of publication of application: **23.09.2026**
(21) Application number: 25864577.9
(22) Date of filing: 16.09.2025
(51) Int. Cl.: G01R 31/74, G01R 31/392, G01R 19/165, G01R 31/327, G01R 31/26, H02J 7/00

(54) **DISCONNECTION IDENTIFICATION DEVICE AND BATTERY PACK COMPRISING SAME**

(30) Priority: 27.12.2024 KR 20240198960
(71) Applicant: LG ENERGY SOLUTION, LTD., Seoul 07335 (KR)
(72) Inventor: HONG, Jung Pyo, Daejeon 34122 (KR)
(74) Representative: Plasseraud IP
(86) International application number: PCT/KR2025/014395
(87) International publication number: WO 2026/141863

(57) **Abstract**

An open-circuit identification device according to an embodiment disclosed herein may be a device that identifies whether a fuse disposed on a charge/discharge line connected to a battery cell included in a battery pack is blown, the open-circuit identification device may be connected to the fuse through a reference node, a first node, and a second node, the open-circuit identification device may include a first filed-effect transistor (FET) connected to the fuse through the first node, a second FET connected to the fuse through the second node, and an integrated circuit (IC) chip configured to identify whether the fuse is blown based on an operating state of at least one of the first FET and the second FET.

## Description

### TECHNICAL FIELD

### Cross-reference to Related Applications

This application claims priority from Korean Patent Application No. 10-2024-0198960, filed on December 27, 2024, the disclosure of which is incorporated by reference herein.

### Technical Field

Embodiments disclosed herein relate to an open-circuit identification device and a battery pack including the same.

### BACKGROUND ART

In recent years, research and development for secondary batteries have been actively conducted. Here, the secondary battery is a battery capable of recharging and discharging, and in its meaning, includes all of the existing Ni/Cd battery, Ni/MH battery, and the like and a recent lithium-ion battery. Among secondary batteries, the lithium-ion battery has the advantage of having a much higher energy density than the existing Ni/Cd battery, Ni/MH battery, and the like. In addition, since the lithium-ion battery may be manufactured to be small and lightweight, the lithium-ion battery is used as a power source for mobile devices, and in recent years, its scope of use has expanded to include power sources for electric vehicles, so that the lithium-ion battery attracts attention as a next-generation energy storage medium.

As the industrial fields utilizing batteries expand, a battery management system (BMS) that diagnoses the safety of batteries is also developing. The BMS may be included in a battery pack, and may diagnose the state of battery cells included in the battery pack utilizing various diagnostic algorithms, and perform appropriate control based on the state of the battery cells.

In particular, the BMS may perform first protection and second protection functions as safety functions. The first protection function may be a function that monitors the voltage and the like of the battery and performs appropriate control, and the second protection function may be a function that controls charging and discharging when the voltage, current, and/or temperature of the battery exceeds limits.

### DISCLOSURE OF THE INVENTION

### TECHNICAL PROBLEM

A battery pack may have a charge/discharge line for supplying power from a plurality of battery cells to a load or for supplying power from a charging device to the battery cells. The charge/discharge line may be equipped with a fuse capable of cutting off power supplied from or to the battery cells. The BMS may perform the second protection function of the battery pack by intentionally blowing the fuse when overvoltage or overcurrent is applied to the battery cells.

For example, when overvoltage is applied to a battery cell, the BMS may control a heater included in the battery pack such that the fuse is intentionally blown by heat generated from the heater. However, when an overcurrent or short-circuit current is applied to the battery cell, since the fuse may be unexpectedly blown by the overcurrent exceeding the allowable current within a short period of time, there is a problem that the BMS may fail to recognize whether the fuse is blown.

The technical problems of the embodiments disclosed herein are not limited to those mentioned above, and other objectives not mentioned will be clearly understood by those skilled in the art from the following descriptions.

### TECHNICAL SOLUTION

According to an embodiment disclosed herein, an open-circuit identification device may be a device that identifies whether a fuse disposed on a charge/discharge line connected to a battery cell included in a battery pack is blown, the open-circuit identification device may be connected to the fuse through a reference node, a first node, and a second node, the open-circuit identification device may include a first filed-effect transistor (FET) connected to the fuse through the first node, a second FET connected to the fuse through the second node, and an integrated circuit (IC) chip configured to identify whether the fuse is blown based on an operating state of at least one of the first FET and the second FET.

In an embodiment, the open-circuit identification device may further include a first resistor connected to the first FET and a second resistor connected to the second FET, and the IC chip may identify whether the fuse is blown based on a first voltage applied to the first resistor based on an operating state of the first FET and a second voltage applied to the second resistor based on an operating state of the second FET.

In an embodiment, the IC chip may identify whether the fuse is blown based on changes in voltage applied to the first resistor and the second resistor.

In an embodiment, the IC chip may identify that a first end of the fuse corresponding to the reference node and the first node is blown when the voltage applied to the first resistor decreases to or below a first threshold value.

In an embodiment, the IC chip may identify that a second end of the fuse corresponding to the reference node and the second node is blown when the voltage applied to the second resistor decreases to or below a second threshold value.

In an embodiment, the open-circuit identification device may further include a communication circuit configured to transmit a result of identifying whether the fuse is blown to a battery management system (BMS).

According to an embodiment disclosed herein, a battery pack may include a battery cell, a fuse disposed on a charge/discharge line connected to the battery cell, and an identification circuit connected to the fuse through at least three nodes and configured to identify whether the fuse is blown.

In an embodiment, the identification circuit may be connected to the fuse through a reference node, a first node, and a second node, and the identification circuit may include a first FET connected to the fuse through the reference node, a second FET connected through the second node of the fuse, and an IC chip configured to identify whether the fuse is blown based on an operating state of at least one of the first FET and the second FET.

In an embodiment, the identification circuit may further include a first resistor connected to the first FET and a second resistor connected to the second FET, and the IC chip may identify whether the fuse is blown based on a voltage applied to the first resistor based on an operating state of the first FET and a voltage applied to the second resistor based on an operating state of the second FET.

In an embodiment, the IC chip may identify whether the fuse is blown based on changes in voltage applied to the first resistor and the second resistor.

In an embodiment, the IC chip may identify that a first end of the fuse corresponding to the reference node and the first node is blown when the voltage applied to the first resistor decreases to or below a first threshold value.

In an embodiment, the IC chip may identify that a second end of the fuse corresponding to the reference node and the second node is blown when the voltage applied to the second resistor decreases to or below a second threshold value.

In an embodiment, the battery pack may further include a battery management system (BMS), and the battery management system may control charging or discharging of the battery cell when it is identified that the fuse is blown.

### ADVANTAGEOUS EFFECTS

An open-circuit identification device and a battery pack including the same according to various embodiments disclosed herein can identify whether a fuse is blown based on current flowing in at least three nodes connected to the fuse, and thus it is possible to identify a blown state of the fuse caused by an overcurrent.

The effects of the battery diagnostic device and the method of operating the same according to the disclosure herein are not limited to the effects mentioned above, and other effects not mentioned will be clearly understood by those skilled in the art according to the disclosure herein.

### BRIEF DESCRIPTION OF THE DRAWINGS

FIG. 1 illustrates an identification circuit for identifying a fuse is blown according to an embodiment disclosed herein and a portion of a battery pack including the same.
FIG. 2 illustrates a circuit diagram inside a battery pack according to an embodiment disclosed herein.
FIG. 3 illustrates a circuit diagram when a fuse is normal, according to an embodiment disclosed herein.
FIGS. 4 and 5 are views for describing a method for identifying whether a fuse is blown by an identification circuit when the fuse is abnormal, according to an embodiment disclosed herein.

With respect to the description of the drawings, the same or similar reference signs may be used for the same or similar elements.

### MODE FOR CARRYING OUT THE INVENTION

Hereinafter, embodiments of the present invention will be described with reference to the accompanying drawings. However, this is not intended to limit the present invention to the specific embodiments, and it is to be construed to include various modifications, equivalents, and/or alternatives of embodiments of the present invention.

It should be appreciated that embodiments of the present disclosure and the terms used therein are not intended to limit the technological features set forth herein to a particular embodiment and include various changes, equivalents, or replacements in corresponding embodiments. With regard to the description of the drawings, similar or related reference numerals may be used to refer to similar or related elements. It is to be understood that a singular form of a noun corresponding to an item may include one or more of the things, unless the relevant context clearly indicates otherwise.

As used herein, each of phrases such as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Terms such as "1st" and "2nd," "first," "second," "A." "B," "(a)," or "(b)" may be used to simply distinguish a corresponding component from another, and do not limit the components in other aspects (e.g., importance or order) unless specifically stated otherwise.

In the present specification, it is to be understood that if an element (e.g., a first element) is referred to, with or without the term "operatively" or "communicatively," as "connected to," "coupled to," or "in contact with" another element (e.g., a second element), it means that the element may be connected to the other element directly (e.g., by wire or wirelessly) or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., a compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the plurality of entities may be disposed separately from other components. According to embodiments disclosed herein, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as those performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

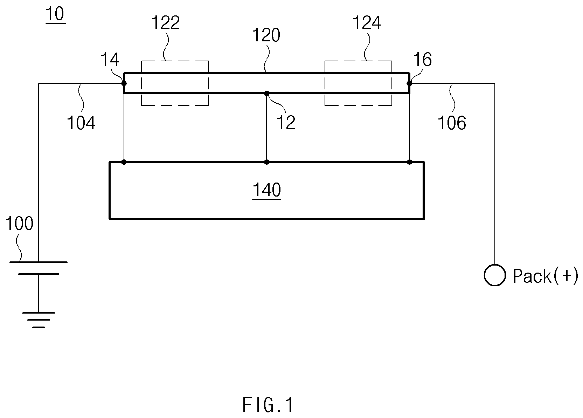

FIG. 1 illustrates an identification circuit for identifying a fuse is blown according to an embodiment disclosed herein and a portion of a battery pack including the same.

Referring to FIG. 1, a battery pack 10 may include a battery cell 100 and an open-circuit identification device 140. A positive terminal of the battery cell 100 may be connected to a terminal Pack(+) of the battery pack by charge/discharge lines 104 and 106 and a fuse 120. Here, the charge/discharge lines 104 and 106 may refer to conductors through which current flows when the battery cell 100 is charged from a charging device or when power of the battery cell 100 is supplied to an external source. For example, when the battery cell 100 is being charged, external power may be supplied to the battery cell 100 through the battery pack terminal Pack(+), and the external power may be finally supplied to the battery cell 100 through the charge/discharge lines 104 and 106 and the fuse 120.

The open-circuit identification device 140 may be connected to the fuse 120 through at least three nodes 12, 14, and 16. Here, the at least three nodes 12, 14, and 16 may include a reference node 12, a first node 14, and a second node 16. The open-circuit identification device 140 may identify whether the fuse 120 is blown based on the current flowing between the reference node 12 and the first node 14 or the second node 16.

The open-circuit identification device 140 may identify whether a first portion 122 and a second portion 124 of the fuse 120 are blown based on the reference node 12.

In an embodiment, the open-circuit identification device 140 may identify whether the first portion 122 of the fuse 120 is blown based on the current flowing between the reference node 12 and the first node 14. The open-circuit identification device 140 may identify whether the second portion 124 of the fuse 120 is blown based on the current flowing between the reference node 12 and the second node 16.

According to an embodiment, the battery pack 10 may further include a battery management system (BMS) (not illustrated). The battery management system may diagnose the state and/or performance of a battery utilizing various diagnostic algorithms and perform appropriate control according to the state of the battery. For example, the battery management system may control charging and discharging of the battery to be stopped when it is identified that the fuse 120 is blown. When the battery pack 10 includes the battery management system, the open-circuit identification device 140 may further include a communication circuit (not illustrated) that transmits, to the battery management system, a result of identifying whether the fuse 120 is blown.

In addition, according to various embodiments, the open-circuit identification device 140 may be included in the BMS, and operations performed by the open-circuit identification device 140 may be performed in the battery management system.

In FIG. 1, one battery cell 100 is illustrated, but this is only for convenience of description, and the battery pack 10 may include a plurality of battery cells respectively connected to a plurality of charge/discharge lines 104 and 106. In addition, each of the plurality of battery cells may include n battery cells (n is a natural number greater than or equal to 2). According to various embodiments, when the battery pack 10 has a cell-to-pack (CTP) structure, the battery pack 10 may be configured to include a plurality of battery cells without distinction between modules.

In an embodiment, the battery pack 10 may be included in the electronic device. Here, the electronic device may be a mobile device (e.g., a mobile phone, a laptop computer, a smartphone, or a smart pad), an electric vehicle (e.g., an electric vehicle (EV), a hybrid EV (HEV), a plug-in HEV (PHEV), a fuel cell EV (FCEV)), or an energy storage system (ESS). The open-circuit identification device 140 may diagnose the fuse forming the charge/discharge lines together with each battery cell inside the battery pack included in the electronic device to determine whether the fuse is blown.

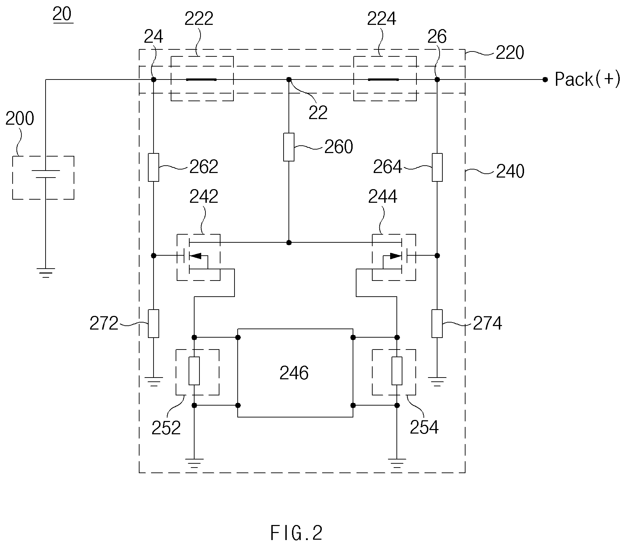

FIG. 2 illustrates a circuit diagram inside a battery pack according to an embodiment disclosed herein.

Referring to FIG. 2, a circuit diagram 20 may a circuit that represents each of the components of the battery pack 10 of FIG. 1 as a circuit element and illustrates connection relationships between them.

Referring to the circuit diagram 20, the reference numeral 240 may represent the open-circuit identification device 140 in FIG. 1, and hereinafter, the reference numeral 240 may be referred to as an identification circuit. The identification circuit 240 may be connected to a fuse 220 through at least three nodes 22, 24, and 26, and the three nodes 22, 24, and 26 may correspond to the three nodes 12, 14, and 26 in FIG. 1, respectively.

The fuse 220 may correspond to the fuse 12 in FIG. 1 and may include a first portion 222 and a second portion 224. The first portion 222 and the second portion 224 may correspond to the first portion 122 and the second portion 124 of the fuse 120 in FIG. 1, respectively. Reference numerals 222 and 224 may be understood as being represented by switching elements to indicate, in the form of a circuit, whether the fuse 120 in FIG. 1 is blown.

In addition to a first resistor 222 and a second resistor 224, other resistors 260, 262, 264, 272, and 274 are resistors for distributing voltage and may be disposed in the circuit diagram 20 so that a gate of each of a first FET() and a second FET() performs operations. For example, a first other resistor 260, a second other resistor 262, and a third other resistor 264 may each have a resistance of 1k ohm, and a fourth other resistor 272 and a fifth other resistor 274 may each have a resistance of 1M ohm. However, the resistance values are merely exemplary and the voltage value may be set differently depending on the current consumption.

Hereinafter, for convenience of description, whether the first portion 122 of the fuse 120 is blown may be represented through an operating state of the first switching element 222, and whether the second portion 124 of the fuse 120 is blown may be represented through an operating state of the second switching element 224.

The conductor connecting the first portion 222 and the battery cell 200 may correspond to the left charge/discharge line 104 in FIG. 1, and the conductor connecting the second portion 224 and the battery pack terminal Pack(+) may correspond to the right charge/discharge line 106 in FIG. 1.

The identification circuit 240 may be connected to the fuse 220 through the at least three nodes 22, 24, and 26. For example, the identification circuit 240 may be connected to the fuse 120 through a reference node 22, a first node 24, and a second node 26. The identification circuit 240 may identify whether the first portion 222 is blown based on the current flowing through the reference node 22 and the first node 24. The identification circuit 240 may identify whether the second portion 224 is blown based on the current flowing through the reference node 22 and the second node 26.

The identification circuit 240 may include a first FET 242, a second FET 244, and an IC chip 246. Here, FET may mean a field-effect transistor and may be a switching element that changes on/off based on an applied voltage. The first FET 242 and the second FET 244 may change their states based on operating states of the first portion 222 and the second portion 224, respectively. The IC chip 246 may identify whether the fuse is blown based on an operating state of at least one of the first FET 242 and the second FET 244.

In addition, the identification circuit 240 may further include a first resistor 252 and a second resistor 254, which are connected to the first FET 242 and the second FET 244, respectively. Both ends of each of the first resistor 252 and the second resistor 254 may be connected to the IC chip 246. The IC chip 246 may identify voltages applied across the first resistor 252 and the second resistor 254.

The IC chip 246 may identify whether the fuse 120 is blown based on the operating state of at least one of the first FET 242 and the second FET 244. In an embodiment, the IC chip 246 may identify a change in voltage applied to the first resistor 252 and the second resistor 254 based on the operating state of at least one of the first FET 242 and the second FET 244, and may identify whether the fuse 120 is blown based on the change in voltage applied to the first resistor 252 and the second resistor 254. For example, a state of the voltage applied to the first resistor 252 and the second resistor 254 may correspond to a high state or a low state depending on the operating state of the first FET 242 and the second FET 244.

Referring to the state of the first portion 222 and the second portion 224, it can be confirmed that the first portion 222 and the second portion 224 are in a non-blown state, and that the charge/discharge line connecting the battery cell 200 and the terminal Pack(+) of the battery pack through the fuse 220 is in a normal state.

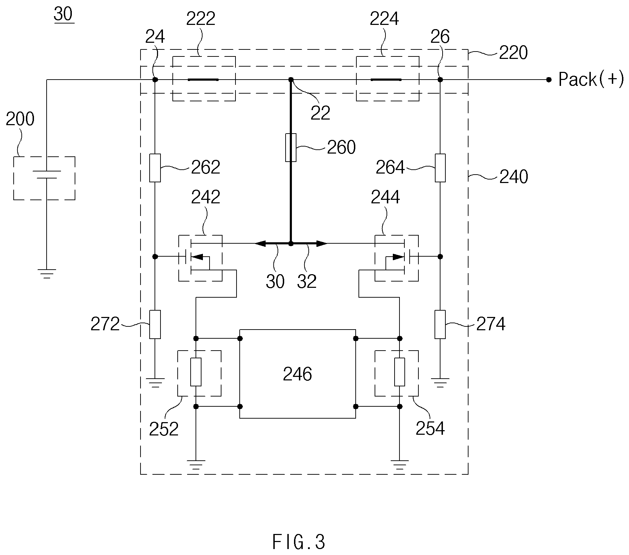

Hereinafter, with reference to FIGS. 3 to 5, a method for identifying whether a fuse is blown by the identification circuit 240 in a state where the fuse in a normal or blown state will be described.

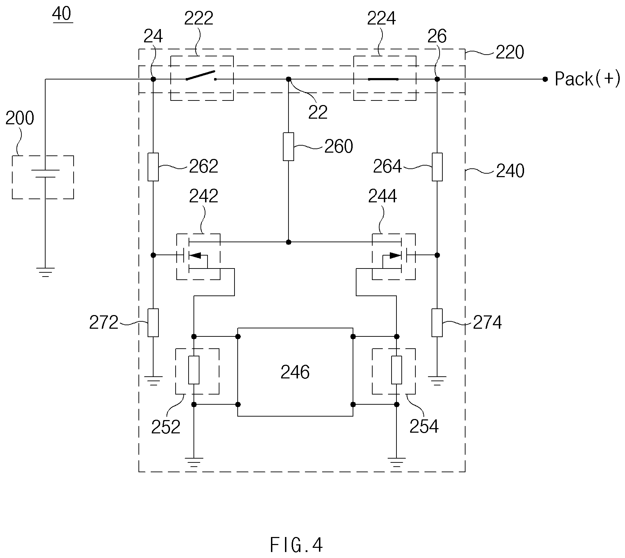

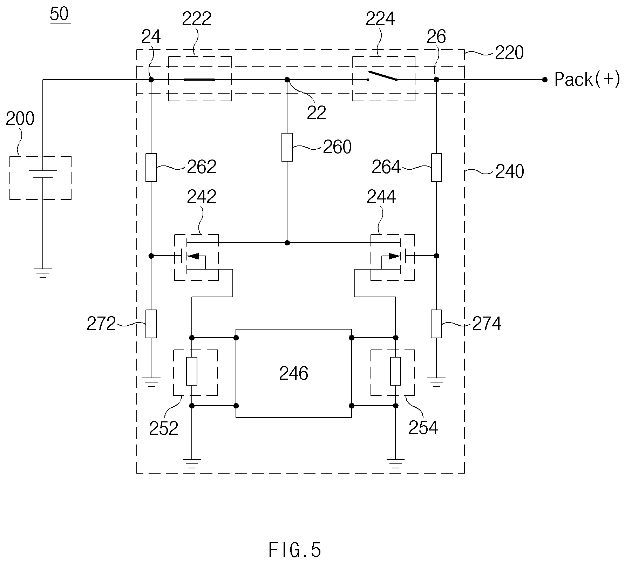

FIG. 3 illustrates a circuit diagram when a fuse is normal, according to an embodiment disclosed herein. FIGS. 4 and 5 are diagrams for describing a method for an identification circuit to identify whether a fuse is blown when the fuse is abnormal according to an embodiment disclosed herein.

Referring to FIG. 3, a circuit diagram 30 may represent a circuit diagram of a state where the first portion 222 and the second portion 224 are not blown, representing a case where a fuse is normal.

Referring to the circuit diagram 30, when current is transmitted from the battery cell 200 toward the battery pack terminal Pack(+), the operating states of the first FET 242 and the second FET 244 may be determined based on whether the fuse 220 is blown. Specifically, the first FET 242 and the second FET 244 may be turned on by the current, and based on this, current may be transmitted in a first direction 30 and a second direction 32. In this case, the current is transmitted from drains of the first FET 242 and the second FET 244 to the sources, so that the voltages across the first resistor 252 and the second resistor 254 may be maintained in a high state. The identification circuit 240 may identify that the state of the fuse 220 is normal when the voltages across the first resistor 252 and the second resistor 254 are maintained in the high state.

FIG. 4 illustrates a method for identifying whether a fuse is blown by the identification circuit when the fuse is abnormal (the left side of the fuse is blown), according to an embodiment disclosed herein. Referring to FIG. 4, a circuit diagram 40 may represent a circuit diagram of a state where a first switching element 222 is turned off and a second switching element 224 is turned on, representing a case where the left side of the fuse is blown.

Referring to the circuit diagram 40, when current flows from the battery cell 200 toward the battery pack terminal Pack(+), current does not flow between the first node 24 and the reference node 22 due to the fact that the first switching element 222 is open. Based on this, the voltages applied across the first resistor 252 and the second resistor 254 may be changed from a high state to a low state. The identification circuit 240 may identify that the left side of the fuse is blown when the voltages applied across the first resistor 252 and the second resistor 254 are changed to the low state.

Specifically, as the flow of current between the drain and source of the first FET 242 and the second FET 244 is blocked, current does not flow to the first resistor 252 and the second resistor 254. In this case, the voltages applied across the first resistor 252 and the second resistor 254 may become low. The IC chip 246 may identify that the connection between the reference node 22 and the first node 24 is open when the voltages across the first resistor 252 and the second resistor 254 are in the low state.

FIG. 4 illustrates a method for identifying whether a fuse is blown by the identification circuit when the fuse is abnormal (the right side of the fuse is blown), according to an embodiment disclosed herein. Referring to FIG. 5, a circuit diagram 50 may represent a circuit diagram of a state where the first switching element 222 is turned on and the second switching element 224 is turned off, representing a case where the right side of the fuse is blown.

Referring to the circuit diagram 50, when current flows from the battery cell 200 toward the battery pack terminal Pack(+), current does not flow between the reference node 22 and the second node 26 due to the fact that the second switching element 224 is open. Based on this, the voltage of the first resistor 252 remains is maintained in a high state, but the voltage of the second resistor 254 may be changed from a high state to a low state. The IC chip 246 may identify that the right side of the fuse is blown when only the voltage applied across the second resistor 254 is changed from the high state to the low state.

Specifically, a high voltage is applied to the gate of the first FET 242 and current flows between the drain and source of the first FET 242, thereby maintaining the voltage across the first resistor 252 in the high state. On the other hand, since the gate voltage of the second FET 244 is maintained in the low state due to the second switching element 224 being in the off state, the voltage across the second resistor 254 may become low. The IC chip 246 may identify that the connection between the reference node 22 and the second node 26 is open when the voltage across the second resistor 254 is in the low state.

In the above, the fuse 220 and the identification circuit 240 have been described as being connected through three nodes 22, 24, and 26, but this is only for convenience of description and is not limited thereto. According to an embodiment, the fuse 220 and the identification circuit 240 may be connected through four or more nodes. In this case, in addition to the first portion 222 and the second portion 224, the identification circuit 240 may also diagnose other portions to determine whether an open circuit occurs therein.

Terms such as "include," "comprise," or "have" described above mean that the corresponding component may be present unless otherwise stated, and thus it should be construed that other components may be further included rather than excluding other components. All terms including technical or scientific terms have the same meaning as commonly understood by those of ordinary skill in the art to which embodiments disclosed herein belong, unless otherwise defined. Terms commonly used such as those defined in dictionaries should be interpreted as having a meaning that is consistent with their meaning in the context of the related art and will not be interpreted in an idealized or overly formal sense unless expressly so defined herein.

The above description is merely an example of the technical idea disclosed herein, and those with ordinary skill in the art to which the embodiments disclosed herein belong may make various modifications and variations without departing from the essential characteristics of the embodiments disclosed herein. Accordingly, the embodiments disclosed herein are not intended to limit the technical ideas of the embodiments disclosed herein but rather to explain them, and the scope of the technical ideas disclosed herein is not limited by these embodiments. The scope of protection disclosed herein should be interpreted by the accompanying claims, and all technical ideas within the scope equivalent thereto should be construed as being included in the scope of rights herein.

## Claims

1. An open-circuit identification device that identifies whether a fuse disposed on a charge/discharge line connected to a battery cell included in a battery pack is blown, the open-circuit identification device being connected to the fuse through a reference node, a first node, and a second node, the open-circuit identification device comprising:
a first filed-effect transistor (FET) connected to the fuse through the first node;
a second FET connected to the fuse through the second node; and
an integrated circuit (IC) chip configured to identify whether the fuse is blown based on an operating state of at least one of the first FET and the second FET.

2. The open-circuit identification device of claim 1, further comprising:
a first resistor connected to the first FET; and
a second resistor connected to the second FET,
wherein the IC chip identifies whether the fuse is blown based on a first voltage applied to the first resistor based on an operating state of the first FET and a second voltage applied to the second resistor based on an operating state of the second FET.

3. The open-circuit identification device of claim 2, wherein the IC chip identifies whether the fuse is blown based on changes in voltage applied to the first resistor and the second resistor.

4. The open-circuit identification device of claim 3, wherein the IC chip identifies that a first end of the fuse corresponding to the reference node and the first node is blown when the voltage applied to the first resistor decreases to or below a first threshold value.

5. The open-circuit identification device of claim 3, wherein the IC chip identifies that a second end of the fuse corresponding to the reference node and the second node is blown when the voltage applied to the second resistor decreases to or below a second threshold value.

6. The open-circuit identification device of claim 1, further comprising a communication circuit configured to transmit a result of identifying whether the fuse is blown to a battery management system (BMS).

7. A battery pack comprising:
a battery cell;
a fuse disposed on a charge/discharge line connected to the battery cell; and
an identification circuit connected to the fuse through at least three nodes and configured to identify whether the fuse is blown.

8. The battery pack of claim 7, wherein the identification circuit is connected to the fuse through a reference node, a first node, and a second node, and
the identification circuit includes:
a first FET connected to the fuse through the first node;
a second FET connected through the second node of the fuse; and
an IC chip configured to identify whether the fuse is blown based on an operating state of at least one of the first FET and the second FET.

9. The battery pack of claim 8, wherein the identification circuit further includes:
a first resistor connected to the first FET; and
a second resistor connected to the second FET, and
the IC chip identifies whether the fuse is blown based on a voltage applied to the first resistor based on an operating state of the first FET and a voltage applied to the second resistor based on an operating state of the second FET.

10. The battery pack of claim 9, wherein the IC chip identifies whether the fuse is blown based on changes in voltage applied to the first resistor and the second resistor.

11. The battery pack of claim 10, wherein the IC chip identifies that a first end of the fuse corresponding to the reference node and the first node is blown when the voltage applied to the first resistor decreases to or below a first threshold value.

12. The battery pack of claim 10, wherein the IC chip identifies that a second end of the fuse corresponding to the reference node and the second node is blown when the voltage applied to the second resistor decreases to or below a second threshold value.

13. The battery pack of claim 7, further comprising a battery management system (BMS),
wherein the battery management system controls charging or discharging of the battery cell when it is identified that the fuse is blown.
